# EUROPEAN PATENT APPLICATION

(11) **EP 3 199 904 A2**
(43) Date of publication of application: **02.08.2017**
(21) Application number: 16203299.9
(22) Date of filing: 09.12.2016
(51) Int. Cl.: F41A 31/02, G01R 33/12

(54) **IMPROVEMENTS RELATING TO THE FORENSIC INVESTIGATION OF GUNS**

(30) Priority: 10.12.2015 US 201562265782 P
(71) Applicant: Metrasens Limited, Malvern, Worcestershire WR14 1GL (GB)
(72) Inventor: KEENE, Mark Nicholas, Malvern, Worcestershire WR14 4LF (GB)
(74) Representative: Tranter, Andrew David

(57) **Abstract**

A method for determining the elapsed time after discharge of a firearm (300) is disclosed. After the firearm has been initially discharged, the method comprises steps of measuring the magnetization of the barrel to obtain an initial measurement, allowing the magnetization of the firearm to relax to a base level, then discharging the firearm, measuring the magnetization of the barrel a plurality of times over a given time period to produce a base calibration of the relaxation of the magnetization as a function of time; and applying this base calibration to the initial measurement, to determine an elapsed time since being initially discharged.

## Description

### FIELD OF THE INVENTION

The present invention relates to the field of ballistics, and more particularly to a method of determining the time when a firearm was last discharged. The invention also relates to an apparatus for use in this determination.

### BACKGROUND OF THE INVENION

It is known to use physical evidence in order to determine a sequence of events or happenings, especially where there are no witnesses on which to rely. In particular, these methods of extracting information are used in crime scenes. In such cases, there may be no witnesses, or human evidence may not be reliable, for a variety of potential reasons. Thus, experts may be called upon to obtain this critical information.

Of particular importance, especially in the field of crime investigation, may be information which may prove or disprove whether a particular weapon was used at the scene of the crime. Considering firearms, whilst it may be possible, given the correct circumstances, to prove that a firearm discharged a particular bullet, by way of ballistic fingerprinting, there has not previously been any manner in which to determine whether or not a firearm has been discharged at a particular time.

Previous attempts to determine this information have been beset by severe disadvantages. For instance, it may be theoretically possible to detect an increase in heat in the firearm due to its discharge. However, this evidence is very short-lived and may be non-indicative after an hour has elapsed. Its accuracy may also be affected by external factors such as ambient temperature, making it inaccurate. Similar methods which involve olfactory techniques or analysis of cordite residue suffer from similar drawbacks.

It is an object of the present invention to provide a technique which overcomes these problems to allow more accurate and useful analysis of firearms.

### BRIEF SUMMARY OF THE INVENTION

According to a first aspect of the invention there is provided a method for determining the elapsed time after discharge of a firearm, comprising the steps of: a] providing a firearm having a barrel, the firearm having been initially discharged; b] measuring the magnetization of the barrel to obtain an initial measurement; c] allowing the magnetization of the firearm to relax to a base level; d] discharging the firearm; e] measuring the magnetization of the barrel a plurality of times over a given time period to produce a base calibration of the relaxation of the magnetization as a function of time; and f] applying this base calibration to the initial measurement, to determine an elapsed time since being initially discharged.

Measuring the magnetization of a firearm in this manner allows an elapsed time after discharge (ETAD) to be estimated and thus the time of discharge to also be estimated. This information has not previously been obtainable through investigation.

Preferably, in step d] the discharging of the firearm may be imitative of a predicted discharge pattern of the initial discharge. The predicted discharge pattern may be based upon an indication of a number of bullets initially discharged. In this manner a more accurate ETAD may be determined.

In one embodiment of the method, in step c] the magnetization of the barrel may be measured a plurality of times over a given time period to produce an initial calibration of the relaxation of the magnetization as a function of time. Additionally, step d] and step e] may be repeated for different discharge patterns of the firearm, a plurality of base calibrations being produced, the initial calibration being matched to the base calibrations to determine a selected base calibration, the selected base calibration then being used as the base calibration of step f]. Thus, further accuracy and confidence in the resultant ETAD may be achieved.

It may be beneficial to determine the elapsed time after discharge as a range of possible values. Where a specific value is not obtainable, a range may give a good indication of the likelihood of any event having occurred.

According to a second aspect of the invention, there is provided an apparatus for measuring the magnetization of a barrel of a firearm, comprising: a magnetometer; and a firearm location means for guiding the firearm to a predetermined and repeatable position and orientation relative to the magnetometer.

The apparatus enables simple and repeatable measurements of the magnetization of the barrel of the firearm to be taken.

Preferably, the apparatus may further comprise a magnetic shield for the reduction of the influence of external magnetic fields within the apparatus. The magnetic shield may provide protection from external magnetic fields, minimizing errors of the apparatus.

In a preferred embodiment, the firearm location means may include a barrel-locating rod receivable in the barrel of the firearm. Thus, the firearm may be positively located relative to the magnetometer.

More preferably, the firearm location means includes an orientation rod for abutting a receiver of the firearm. Thus, the orientation of the firearm may also be repeated in a simple manner.

The apparatus may be portable and may be sized to fit inside a single carry case to allow it to be easily carried to a crime scene. The firearm location means, or the magnetic shield, or both, may be collapsible to reduce the size for packing. The total apparatus weight may be less than 20 pounds.

According to a third aspect of the invention there is provided a kit comprising instructions for implementation of the method in accordance with the first aspect of the invention; a magnetometer; and a firearm location means for guiding a firearm to a predetermined and repeatable position and orientation relative to the magnetometer.

### BRIEF DESCRIPTION OF THE SEVERAL VIEWS OF THE DRAWINGS

Figure 1 is a flow chart of the method of the present invention;
Figure 2 is a chart showing the typical magnetization of a firearm after discharge and during testing using the method of Figure 1;
Figure 3 shows the typical arrangement of the magnetic field around a firearm;
Figure 4 shows a typical arrangement of a firearm in relation to a magnetometer;
Figures 5 to 7 depict three embodiments of the apparatus for carrying out the method of Figure 1; and
Figure 8 shows an automated apparatus for carrying out the method of Figure 1.

### DETAILED DESCRIPTION OF THE INVENTION

The present invention relies on the principle of magnetic relaxation and the ability of ferromagnetic materials to be magnetized when exposed to shockwaves. When a bullet is discharged from a barrel of a firearm such as a gun, a strong shockwave propagates along the barrel and is reflected several times between the muzzle and the receiver. This mechanical shockwave affects the ferromagnetic order within the steel of the barrel. The magnetic domains in the barrel steel are put into a metastable magnetic state which is different from the relaxed magnetic state when the gun has not been used for a long time. This metastable state then decays over time by the process of magnetic relaxation to its original relaxed state.

The state of magnetization of the barrel is responsible for generating an external magnetic field surrounding it. Therefore, this external magnetic field changes in accordance with the barrel magnetization and will also display a decaying characteristic after the bullet has been discharged. This external field may be measured using a magnetometer. It has therefore been found by the applicant that it is possible to determine the elapsed time after discharging the firearm by measurement of the magnetization of the barrel of the discharged firearm.

In order to take advantage of the principle of magnetic relaxation when making such measurements, it is important to consider various issues. Firstly, there are a large variety of firearms which use a great number of different steels which may have different magnetic properties. It has been found that even amongst identical firearms utilizing steels having identical magnetic properties, their actual magnetization can vary by orders of magnitude, depending on the individual gun's exposure to past magnetic fields, for instance. The initial magnetization of a firearm, along with its magnetic relaxation properties will also differ depending at least upon the number of round fired. Thus, there is no universal magnetic relaxation, even within the same family of guns. The method of the present invention overcomes even these difficulties.

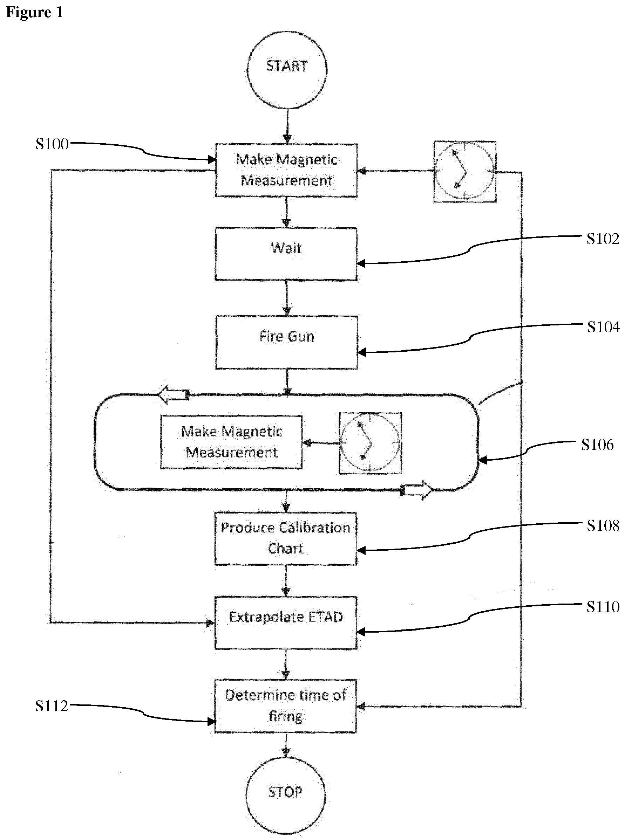

Now referring to Figure 1, there is depicted a flow chart of the method of the present invention. In an exemplar situation, a firearm such as a gun may be recovered from the scene of a crime. Along with the recovery of the firearm, it is also advantageous for the number of bullets discharged from the weapon to be known and recorded. However, this may not be a requisite of the present method, and circumstances where this information is not available will be discussed later. In the present embodiment, the bullets may be recovered from the scene and matched to the firearm, for example by forensic fingerprinting.

The firearm may now have its external magnetic field measured, S100. This measurement may be taken in a forensics laboratory, for instance, or in any other place where the required equipment is available. The sooner this initial measurement is taken, the more accurate can be the determination of the elapsed time after discharge (ETAD), in due course. Along with the magnetic measurement, the time of the measurement is also recorded.

The magnetic measurement may preferably be taken by a magnetometer from a position just in front of the muzzle. Thus, the magnetization of the barrel may be measured as accurately as possible without being unduly affected by any magnetic properties of the receiver of the firearm.

Once the initial measurement has been taken, the firearm must be allowed to return to its magnetically relaxed base state, S102. This waiting period may typically be around 40 hours, although this period may be longer or shorter, depending on the properties of the firearm.

Once relaxed to its base state, the firearm may be discharged, S104. Preferably, it may be discharged a number of times equal to that which it was discharged at the crime scene, if this information is available. The sequence or pattern of firing may also be simulated, such as two rapid firings followed by a third after a short break. Such information may be obtained through eyewitness accounts or electronic recordings, for instance. If any of this information is not available, further steps may be required, which are the subject of a further embodiment.

Once the firearm has been discharged, it is subjected to further measurements of its external magnetic field, S106. In order that the measurements are seen to be comparable, it is desirable for the same testing apparatus to be used for the further measurements as the initial measurement. The further measurements should be taken over a prolonged period of time and preferably until the firearm magnetization returns to its base state. As mentioned previously, this may take around 40 hours. The decay of the magnetization is logarithmic against time and therefore it may be advantageous to measure the external magnetic field firstly at short intervals and then at longer intervals later in the procedure. The measurements of external magnetic field at specific times after discharge may then be plotted to produce a calibration chart indicative of base calibration, S108. Although discussed herein as a calibration chart, it may also be possible to record the data in other ways such as in a database, for instance.

By use of the calibration chart, the ETAD may be determined, S110, through matching of the value to, for instance, a line of best fit on the calibration chart. By then subtracting the ETAD from the time of the initial measurement, the time of discharge may be determined, S112.

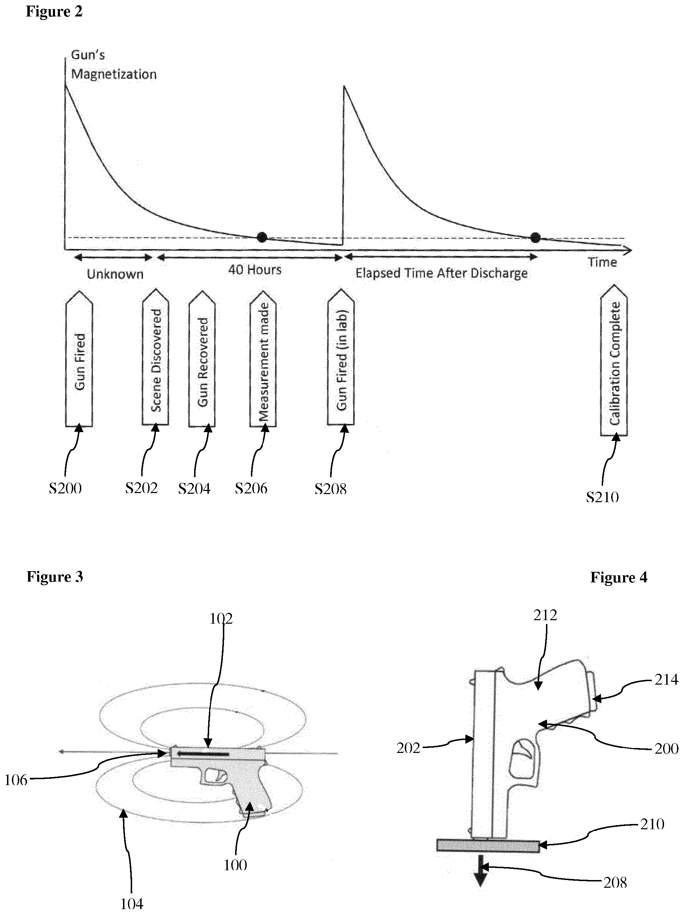

Figure 2 shows the time evolution of the magnetization of a firearm throughout the process, beginning from when the firearm was discharged at an unknown time, S200. Significant events are labelled below the axis. After the initial firing, the magnetization changes and then slowly relaxes over time. Sometime later, the scene is discovered by an authority, S202, and the time of this will normally be noted. All subsequent timings are known, but the time between last discharge and the discovery of the scene is unknown. The firearm may be recovered from the scene, S204, and transported to a laboratory with the appropriate measuring apparatus. There, the initial measurement is taken and a magnetization value or associated magnetic field value is recorded, S206. It is important that the firearm continues to undergo magnetic relaxation until it has reached its normal state. This can be 40 hours or shorter or longer or determined by continuous measurements on the firearm. Once this state is reached, the firearm is discharged, S208, and a series of measurements is made to plot a calibration curve, S210. From this curve, the ETAD may be determined.

Given the basic method, other improvements may be utilized in certain situations. One preferred method is to continually, or at intervals, measure the magnetic relaxation of the firearm after the initial measurement. This may be automated by use of an automatic measurement system and may therefore not be limited by cost or manpower. The continuous or interval-based measurement may then provide a series of data points indicative of an initial calibration to compare with the later base calibration. This will have the additional benefit of directly indicating when the magnetization has fully relaxed and the calibration can begin.

Furthermore, if there is no reliable information on the number of shots fired, a base calibration may be conducted for each possible iteration, e.g. one shot, two shots, three shots, etc. The initial calibration may then be matched to one of the resultant base calibrations in order to find the best match. Each iteration is likely to have a different decay curve, and therefore by matching the curves, the number of bullets and/or discharge pattern of the firearm may also be determined, in addition to then matching the values to find the ETAD.

There may be errors in the measurements taken as a result of random noise, for instance. If the signal-to-noise ratio on the measurements is good enough the method may determine the number of bullets fired and also the time at which they were fired. If the signal-to-noise ratio is not good enough, then the method may still put boundaries on the scenario. For example, it may be possible to determine that if one bullet was fired then the ETAD would be 12 hours, or if two bullets were fired then the ETAD would be 15 hours, etc. Corroboration with other information such as witness accounts may then narrow the time window.

Error analysis may determine the boundaries of the time window within which the firearm was discharged, which may be known as the discharge window. This is determined by the measurement errors and the reproducibility of the magnetic relaxation properties of the firearm, and will need to be calculated on a case-by-case basis. If an improved confidence in the discharge window or a narrower window is required, the calibration stages may be repeated several times to gain a statistical understanding of the errors. It is important to note that, if by the time the initial measurement is taken the firearm is already in its fully relaxed state, the calibration may still be useful to determine the latest time that the firearm could have been discharged.

Whilst the method has so far been described with reference to a laboratory having the required measurement equipment, it may be preferable or desirable for the initial measurement, at least, to be taken at the scene using a portable instrument, provided that this instrument is calibrated against any other instrument involved in the ongoing method. As with any decaying signal, the signal-to-noise ratio decreases with time, so therefore it is advantageous to take the initial measurement as soon as possible. Use of a portable instrument would therefore be likely to result in a more accurate ETAD due to the higher signal-to-noise ratio available from an earlier initial measurement.

Three established physical principles are relevant to understanding the need for some of the features of the present invention. Magnetization, defined as the magnetic moment per unit volume, of any ferromagnetic body has two contributions: induced magnetization and permanent magnetization. These may also be referred to as soft and hard magnetizations, respectively.

Induced magnetization is a contribution that is in the direction of any externally applied field, such as the Earth's magnetic field. Its direction is not strongly influenced by the orientation of the object. Permanent magnetization is formed by the object and its vector orientation is fixed with respect to, and thus rotates with, the object. The overall magnetization is therefore the sum of these contributions. For the purposes of the invention, the change in magnetization is due to a change in the permanent magnetization. Therefore, the induced magnetization is an unwanted factor of the measurement.

The second physical principle is that long and thin ferromagnetic objects have a preferred magnetization direction which is along the long dimension. As shown in Figure 3, firearms 100 therefore have a preferred magnetization direction along their barrel 102 giving rise to an external magnetic field 104. It should be noted that there is no preference for the polarity of the magnetization; it can point towards or away from the muzzle 106.

Thirdly, measuring the external magnetic field 104 is considerably simpler than measuring the actual magnetization. The external field is strongly related to the magnetization. Providing the field is measured in a consistent manner for this method, the results will be equivalent. Thus, the preferred measurement is the vector magnetic field in the direction of the barrel at a fixed set distance. An example is shown in Figure 4.

A vector magnetometer 208 is represented by an arrow to indicate its sensitive direction. Alternatively, a scalar magnetometer may instead be used. The magnetometer 208 must be able to measure DC fields or DC field differences and be sensitive to the small changes in magnetic field associated with the measurements to be taken. Examples of such magnetometers include fluxgates, superconducting quantum interferences devices (SQUIDs), and magneto-resistive sensors. In the present example, the firearm 200 is set so that its barrel 202 is aligned with the magnetometer 208 and a set distance away, defined by a spacer 210. A further advantage of this arrangement is that the magnetic fields from the non-barrel components such as the receiver 212, magazine 214, etc., are as far as possible from the magnetometer 208 and therefore their influence is diminished. The required measurement is the difference between the magnetometer 208 outputs between when the firearm 200 is present and absent. Thus, any error associated with an ambient magnetic field is removed.

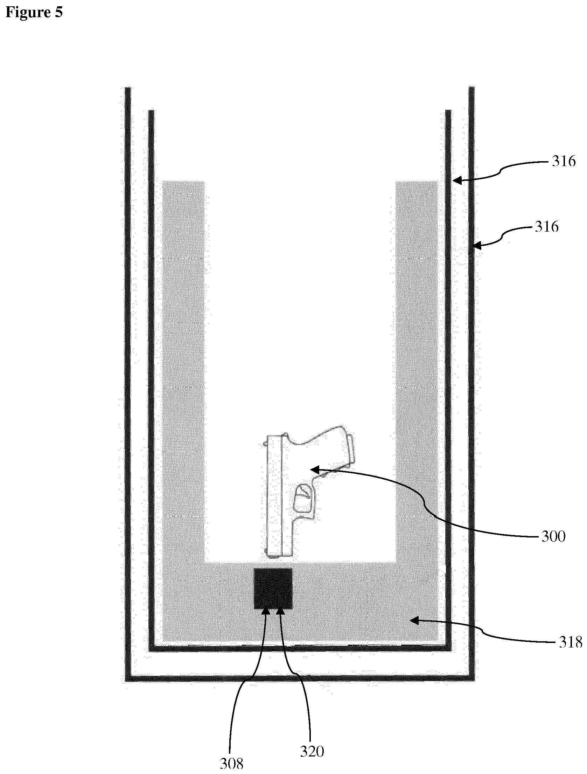

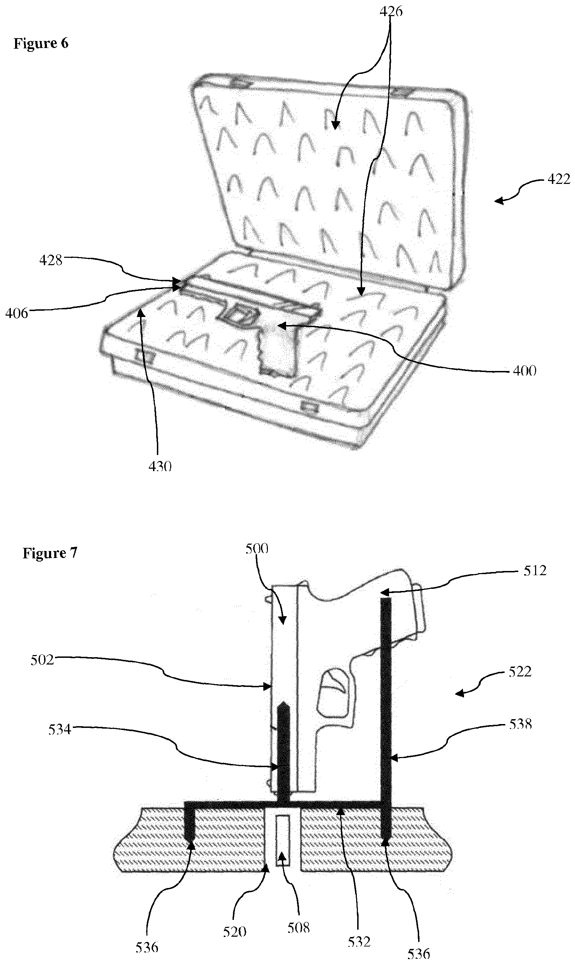

A preferred embodiment is shown in Figure 5 which includes a magnetic shield 316. Such a magnetic shield 316 drastically reduces the influence of the Earth's magnetic field and any fluctuations associated with ferromagnetic objects moving in the surrounding environment. Removing or depleting the effects of the ambient magnetic field also prevents or limits induced magnetization of the firearm 300, leaving a more accurate measurement of the magnetic field resulting from the permanent magnetization. Preferably, the magnetic shield 316 may be a high permeability mu-metal cylinder, closed at one end. Multiple nested magnetic shields 316, such as the two shown in Figure 5, may also improve the performance of the magnetic shielding. Within the magnetic shield 316 is a main housing 318 within which is located a sensor housing 320. The sensor housing 320 includes the magnetometer 308. The main housing 318 may also provide support for, or form a part of, a firearm location means for locating the firearm 300 relative to the magnetometer 308. The firearm location means is not shown in Figure 5. In order to produce reliable and repeatable measurements, the firearm 300 must be accurately and reproducibly positioned relative to the magnetometer 308. Thus, the firearm location means should be formed so as to allow both the position and orientation of the firearm to be standardized for each reason. Two such embodiments of the firearm location means 422, 522 are shown in Figures 6 and 7.

Figure 6 depicts a non-magnetic case 422, preferably formed of wood or plastics, into which the firearm 400 may be placed. The case contains a filler 426, such as a compressible foam or a pre-shaped insert, which holds the firearm 400 in position when closed. The muzzle 406 of the firearm 400 is aligned with a locating mark 428 on the case 424 and placed to be in contact with an inside edge 430 of the case 424 itself. The case 424 may then be placed within the main housing 318 of Figure 5. The case 424 is thus designed, in this embodiment, to fit snugly within the main housing 318 of Figure 5, to ensure a repeatable location of the firearm 400.

Although described as a case, it is not required that the firearm location means be a case and it may instead be a frame or any other structure into which a firearm may be located accurately and reproducibly, and which itself may be accurately and reproducibly located relative to the magnetometer.

An alternative firearm location means 522 is shown in Figure 7. The firearm location means 522 includes a frame 532 having a barrel-locating rod 534 which is receivable within the barrel 502 of the firearm 500. The barrel-locating rod 534 may be matched to the caliber of the firearm 500 to ensure a good fit. The frame 532 is receivable within holes 536 in the main housing 518 such that the barrel-locating rod 534 and therefore barrel 502 of the firearm 500 is positioned adjacent to the sensor housing 520 and magnetometer 508. The frame also includes an orientation rod 538, against which may abut the handle 512 of the firearm 500. Thus, the orientation of the firearm 500 may also be repeatable.

In order to allow a variety of different firearms to be located relative to the magnetometer, the frame may come in different sizes such that the barrel-locating rod is suitable for use with different caliber firearms. Alternatively, adapters may be provided which accommodate differences in size. It is necessary for the firearm location means to be non-ferromagnetic such that it does not interfere with the readings of the magnetometer. Thus, aluminum, wood, or plastics may be used, amongst other allowable materials. Although the firearm location means has been discussed in reference to two particular embodiments, these are not limiting to the present invention and other devices, both simpler and more complex, may be utilized to the same end.

For instance, although an orientation rod has been discussed, this may not be entirely necessary and instead a marking may be provided on the firearm location means or the main housing, for instance, which indicates the required orientation of the firearm, at which point a user may line the firearm up with the marking. This is purely an example and other options will be foreseeable by those skilled in the art.

The embodiments discussed herein are not intended to be limiting to the invention. Whilst a main housing and magnetic shielding are discussed, these are not intrinsic to the invention. In practice, the firearm location means must be able to locate the firearm in a repeatable position relative to the magnetometer and other features may give optional benefits. For instance, having a sensor housing around the magnetometer provides protection, but is not necessary, and the main housing need not be provided if other means are provided for locating the magnetometer, for instance by it being receivable within the firearm location means.

If the magnetic shielding is not included, it may be desirable to orientate the magnetic shield and firearm such that the firearm points in an East-West direction in order that the induced magnetization is minimized. The method may otherwise remain the same.

The taking of measurements of magnetic field or magnetization may require the firearm to be in place and then removed in order to measure the change in magnetic field. This would remove any offset in the magnetometer. If the magnetometer has some drift then three measurements may be taken; firearm absent, firearm present, firearm absent. In this manner, the linear drift of the magnetometer may be compensated for using the resultant measurements as well as the determined offset.

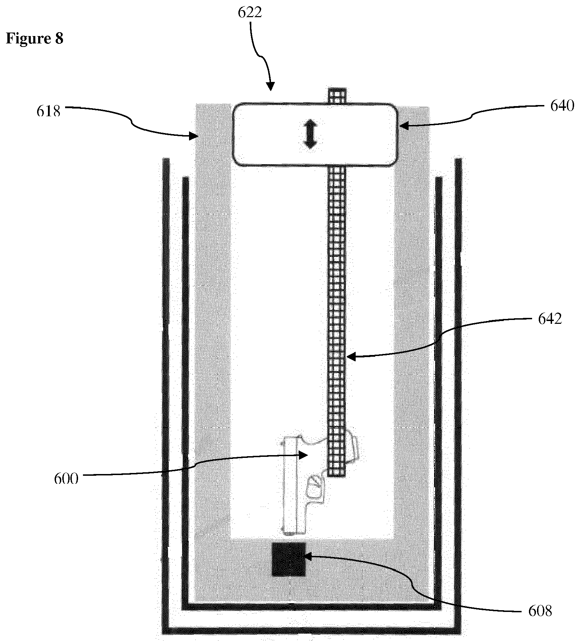

In the embodiments of Figures 6 and 7, the removal and replacement of the firearm is a manual operation. However, this removal may also be achieved automatically by use of, for example, the embodiment of Figure 8. Like features have been given like references and further detailed description has been omitted, for brevity.

The firearm location means 622 of Figure 8 includes a main body 640, receivable within the main housing 618 of the apparatus, and an adjustable arm 642 which is engageable with the firearm 600 to hold it in a repeatable location. The adjustable arm 642 is automatically adjustable such that the firearm 600 may be brought into the proximity of the magnetometer 608 and then removed, to enable the previously described multiple measurements to be taken. The adjustable arm 642 may be driven by an electric motor located within the main body 640, for instance, or by any other means suitable for altering the position of the firearm 600 whilst it is engaged with the adjustable arm 642.

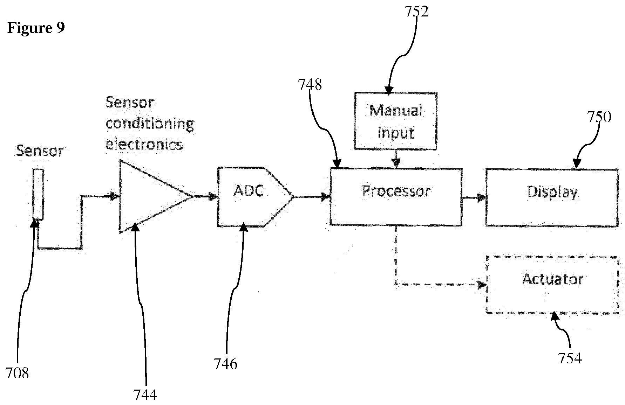

The measurement and automation process is depicted in Figure 9. The sensor, which is a magnetometer 708, may need signal conditioning, achieved by use of sensor conditioning electronics 744, prior to being digitized by use of an analog to digital converter (ADC) 746. The functions of the magnetometer 708, sensor conditioning electronics 744, and ADC 746 may be combined into a magnetometer with a digital output. A processor 748, display 750, and a manual input means 752, such as a mouse or keyboard, may also be provided. These may be combined into a standard unit, for instance a laptop or desktop computer. The processor 748 may run algorithms for signal conditioning or filtering the signal from the magnetometer 708. It may also record and store the measurements. Alternatively, separate memory may be provided for this purpose.

The processor 748 may also prompt a user, by activation of the display 750, to place the firearm for a measurement. A manual input may be required to trigger the next measurement once the manual positioning of the firearm has been completed. Alternatively, measurements may be automatically conducted if an actuator 754 or robotic arm, such as the adjustable arm 642 of Figure 8, is employed.

The processor 748 may further store the measurements and collate any calibrations including generation of a calibration curve or line of best-fit. The ETAD may also be automatically calculated and displayed, along with the time of firing. Furthermore, error margins or limits may be calculated or estimated.

Although the system described for taking measurements is computerized, the output of the magnetometer 708 may instead be output on a voltmeter, for instance, in order that manual recording may take place.

## Claims

1. A method for determining the elapsed time after discharge of a firearm, comprising the steps of:
a] providing a firearm having a barrel, the firearm having been initially discharged;
b] measuring the magnetization of the barrel to obtain an initial measurement;
c] allowing the magnetization of the firearm to relax to a base level;
d] discharging the firearm;
e] measuring the magnetization of the barrel a plurality of times over a given time period to produce a base calibration of the relaxation of the magnetization as a function of time; and
f] applying this base calibration to the initial measurement, to determine an elapsed time since being initially discharged.

2. The method of claim 1, wherein in step d] the discharging of the firearm is imitative of a predicted discharge pattern of the initial discharge.

3. The method of claim 1 or 2, wherein the predicted discharge pattern is based upon an indication of a number of bullets initially discharged.

4. The method of any preceding claim, wherein in step c] the magnetization of the barrel is measured a plurality of times over a given time period to produce an initial calibration of the relaxation of the magnetization as a function of time.

5. The method of any preceding claim, wherein step d] and step e] are repeated for different discharge patterns of the firearm, a plurality of base calibrations being produced, the initial calibration being matched to the base calibrations to determine a selected base calibration, the selected base calibration then being used as the base calibration of step f].

6. The method of any preceding claim, wherein the elapsed time since being initially discharged is determined as a range of possible values.

7. An apparatus for measuring the magnetization of a barrel of a firearm, comprising:
a magnetometer; and
a firearm location means for guiding the firearm to a predetermined and repeatable position and orientation relative to the magnetometer.

8. The apparatus of claim 7, further comprising a magnetic shield for the reduction of the influence of external magnetic fields within the apparatus.

9. The apparatus of claim 7 or claim 8, wherein the firearm location means includes a barrel-locating rod receivable in the barrel of the firearm.

10. The apparatus of claim 7 or claim 8, wherein the firearm location means includes an orientation rod for abutting a receiver of the firearm.

11. A kit comprising:
instructions for implementation of the method of claim 1;
a magnetometer; and
a firearm location means for guiding a firearm to a predetermined and repeatable position and orientation relative to the magnetometer.
